(19)

Europäisches
Patentamt

European
Patent Office

Office européen
des brevets

(11) **EP 4 621 419 A1**

(12) **EUROPEAN PATENT APPLICATION**

(43) Date of publication:
**24.09.2025 Bulletin 2025/39**

(21) Application number: **24164652.0**

(22) Date of filing: **19.03.2024**

(51) International Patent Classification (IPC):
**G01R 19/00** (2006.01)    **G01R 31/12** (2020.01)
**G01R 31/58** (2020.01)    **H02H 1/00** (2006.01)
**H02H 3/44** (2006.01)

(52) Cooperative Patent Classification (CPC):
**H02H 1/0015; G01R 31/086; G01R 31/1272;
H02H 3/44;** G01R 31/008; G01R 31/66

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Hamilton Sundstrand Corporation
Charlotte, NC 28217-4578 (US)**

(72) Inventors:
• **BENN, Andrew
  Kenilworth, CV8 1DA (GB)**
• **WAGHMARE, Piyush
  Solihull, B91 1US (GB)**

(74) Representative: **Dehns
10 Old Bailey
London EC4M 7NG (GB)**

(54) **SYSTEM FOR AND METHOD OF IDENTIFYING SERIES ARCING**

(57)    A system (100) for identifying series arcing in an electrical distribution network of an aircraft, including a plurality of local sensors (106, 112, 114), a plurality of local processors (108, 114, 120), and a global processor (101). Each local sensor measures a measurement representative of the voltage, current and/or impedance in a component (104, 110, 116) of the electrical distribution network. Each local processor analyses the measurement measured by the respective local sensor and outputs a signal representative of the complexity of the measurement. The global processor receives the signals from the plurality of local processors, and analyses the signals and determines when series arcing is occurring in the electrical distribution network. The global processor outputs a signal indicative of the series arcing in the electrical distribution network, when it has been determined that series arcing is occurring.

Figure 1

## Description

## FIELD OF TECHNOLOGY

The examples described herein relate to a system for and method of identifying series arcing in an electrical distribution network of an aircraft, in particular for global monitoring of aircraft systems.

## BACKGROUND

During flight of an aircraft, very high voltages pass through the cables and connectors used in the distribution of power throughout the aircraft, as part of an electrical distribution network. This includes through the electrical components, harnesses and power distribution systems of the aircraft. Furthermore, the components and wires of the electrical distribution network are subject to large temperature variations and vibrations, which may lead to wear and damage, for example by rubbing of wires together degrading any insulating coating or cracks forming in connectors from continued expansion and retraction at different temperatures.

Such degradation may cause series arcing within the electrical distribution network. Series arcing can lead to overheating, component damage, reduction in signal quality and overall poor equipment performance.

However, series arcing may be difficult to detect reliably compared to other aircraft faults such as parallel arcing and can often be mistaken for other aircraft faults. Such series arcing may cause significant damage to the electrical distribution network before it is detected.

Arcing faults may be detected locally at the power source or the load, which uses limited information and thus often identifies false positives. Other methods, such as the method described in US 2022/0099724 A1, attempts to solve this issue using a sense wire to obtain additional measurements from the power source or load; however, this is a high voltage wire that may be subject to wear and interference itself.

The present disclosure aims to address these problems.

## SUMMARY

According to this disclosure, there is provided a system for identifying series arcing in an electrical distribution network of an aircraft, comprising:

a plurality of local sensors;
wherein each local sensor is arranged to measure a measurement representative of the voltage, current and/or impedance in a component of the electrical distribution network;
a plurality of local processors;
wherein each local processor is arranged to analyse the measurement measured by the respective local sensor and output a signal representative of the complexity of the measurement;
a global processor arranged to receive the signals from the plurality of local processors;

wherein the global processor is arranged to analyse the signals and determine when series arcing is occurring in the electrical distribution network; and
wherein the global processor is arranged to output a signal indicative of the series arcing in the electrical distribution network, when it has been determined that series arcing is occurring.

Also according to this disclosure, there is provided a method for identifying series arcing in an electrical distribution network of an aircraft, comprising:

each local sensor of a plurality of local sensors measuring a measurement representative of the voltage, current, and/or impedance in a component of the electrical distribution network;
each local processor of a plurality of local processors analysing the measurement measured by the respective local sensor and outputting a signal representative of the complexity of the measurement;
a global processor receiving the signals from the plurality of local processors;
the global processor analysing the signals and determining when series arcing is occurring in the electrical distribution network;
the global processor outputting a signal indicative of the series arcing in the electrical distribution network, when it has been determined that series arcing is occurring.

Series arcing typically occurs owing to a poor connection between electrical contacts in the aircraft, for example as a result of a loose terminal, wire corrosion and/or excessive vibrations. This may lead to repeated breaks in the connection, where electricity discharges through the air between contacts as the connection is broken, i.e. series arcing may occur. The energy discharged between the contacts during series arcing is typically larger than if the connection were unbroken and may damage the electrical components.

Each local sensor is arranged to measure a measurement representative of the voltage, current and/or impendence in a component of the electrical distribution network. For example, the local sensors may monitor the power source and load components, which may be subject to very high voltages. Each local sensor may be proximal to, e.g. mounted on, the component it is monitoring.

During a series arcing event within a component of the electrical distribution network of the aircraft, the behaviour of the voltage, current and/or impedance through the component may change. The complexity of the waveform of the signal may change upon series arcing, e.g. the noise on the signal may increase or decrease. For example, series arcing in the power source of the electrical distribution network may lower the noise on the voltage through the power source, whereas series arcing in a load capacitor may increase the voltage noise and decrease the impedance noise. Series arcing may be identified by analysis of the measurements taken by the plurality of local sensors.

The measurements taken by the plurality of local sensors are sent to a respective local processor. Each local processor may be proximal to the local sensor and/or the component that the local sensor is monitoring. Thus, the local sensor may comprise the local processor and/or the local processor may be proximal to, e.g. mounted on, the component. Each local processor is arranged to analyse the measurements, and output a signal representative of the complexity of each measurement to the global processor.

For example, an AC voltage measurement with a high level of noise may have a high associated complexity, whereas a DC voltage measurement with a low level of noise may have a low associated complexity. Therefore, the signals may encode the information regarding the noise on the measurements and strip out superfluous information, while passing on information relevant to identification of series arcing to the global processor.

The signals representative of the complexities of the measurements taken by each local sensor may allow for significantly less data to be passed to the global processor, compared to if each local sensor were to output the (e.g. raw) measurements directly to the global processor. This may allow for quick and continuous monitoring of the electrical distribution network without the need for systems that can support large amounts of data, such as a data bus or a high speed data transfer link. This may be useful where there are a large number of local sensors being used, e.g. to reduce (e.g. minimise) false positives, and a large amount of data is being output by the plurality of local sensors.

The global processor receives and analyses the signals from the plurality of local processors, in order to identify when series arcing is occurring. As the signals are indicative of the complexity of the measurements, the global processor may be able to quickly identify patterns indicative of series arcing within certain components.

The global processor may correlate the signals indicative of complexity between different components of the electrical distribution network. This may prevent false positives from being flagged as series arcing, e.g. if the complexity of one signal indicates series arcing, but the complexities of other signals contradict this. For example, a signal which may indicate a series arc may actually be a component failure, which may only be identified when the signals are correlated.

Furthermore, if there is only a small series arc, which might go unnoticed upon analysis of a single signal, by correlating a plurality of signals from a plurality of local processors, a pattern may emerge indicating the beginnings of series arcing. Therefore, at least some examples of the present disclosure may allow for series arcing to be determined earlier, and without false positives, compared to existing series arcing detection systems and methods.

When it has been determined that series arcing is occurring, the global processor outputs a signal indicative of the series arcing in the electrical distribution network. For example, the signal may be fed back to a power distribution network responsible for powering the components of the electrical distribution network, e.g. in order to remove power from a component that is experiencing (e.g. particularly severe) series arcing. The signal may be flagged to the pilot and/or be recorded in a maintenance log, e.g. for a particular part to be replaced or connection repaired, such that further series arcing may be prevented on future flights.

The (e.g. each) local processor receives information from (e.g. only) the respective local sensor(s). Therefore, the (e.g. each) local processor is 'local' to its respective local sensor(s), in that it is associated with the respective local sensors(s). In some examples, the (e.g. each) local processor is physically local, e.g. positioned nearby, to the respective local sensors(s). However, although the (e.g. each) local processor receives information from the respective local sensor(s), it will be appreciated that 'local' does not necessarily relate to the physical location of the local processor with respect to the respective local sensor(s). Therefore, in some examples, the (e.g. each) local processor is physically remote from the local sensor(s). In some examples, the (e.g. each) local processor is physically remote from the global processor.

The local processor may be "off-chip" to the respective local sensor(s) and/or the global processor. For example, the local processor may be located in a device external to the respective local sensor(s), or located in a different region of the same device. It will be appreciated that in a remote arrangement, data (e.g. waveform) is generally sent from an off-chip local processor to the global processor. The data may then be discarded after use, e.g. after the global processor has determined whether series arcing is occurring. However, in some examples, the local processors are part of the global processor, e.g. part of the same integrated circuit.

In some examples, each local processor is arranged to perform fractal dimension analysis on the measurement measured by the respective local sensor to determine the complexity of the measurement, e.g. to determine the complexity and/or level of noise associated with the measurement.

The complexity may be defined as the number of higher order contributions within the waveform. For example, the fractal dimension analysis analyses the complexity and/or irregularity of the voltage, current and/or impedance waveform using the relationship

$$D = \frac{\log n}{\left(\log n + \log\frac{d}{L}\right)}$$

, where D is the fractal dimensionality of the waveform, n is the number of steps in the waveform, d is the planar extent of the waveform and L is the total length of the waveform. This may reduce the information encoded in the signal transmitted to the global processor regarding the noise on a measurement measured by each local sensor to only a single number, e.g. a floating point number.

For example, the fractal dimension for a straight line may be D = 1.0, whereas a random-walk waveform be D = 1.15, and very convoluted waveforms may be D = 1.5. Therefore, a higher complexity signal, e.g. a waveform with many higher order contributions, will have a higher fractal dimension.

By reducing the information about each measurement to a single number, there may be less information being transmitted to the global processor, and thus may be transmitted at high speeds. This may provide an improvement on existing arc measurements that transmit measurements based on frequency or time domain analysis and which produce a large dataset unsuitable for high-speed transmission. Furthermore, it may be easier for the global processor to analyse the signals and identify patterns in the noise behaviour, by comparing only single numbers (i.e. with no associated time) representative of the (complexity of the) data from each local sensor.

In some examples, a (e.g. each) local sensor is arranged to measure one of the voltage, current, and/or impedance through a component of the electrical distribution network. For example, each component of the electrical distribution network may comprise more than one associated local sensor, e.g. three local sensors in order to measure the voltage, current and impedance respectively.

In some examples, each local sensor has a respective local processor, i.e. there may be a 1:1 ratio of local sensors to local processors. In some examples, each component may have a respective local processor, e.g. each local processor is arranged to receive measurements from a plurality of local sensors associated with that component. By grouping the local processor to the group of local sensors for that component, when the global processor receives signals from each local processor, it may be easier to classify which component each signal is associated with.

In some examples, the global processor is arranged to receive information regarding the arrangement of the electrical distribution network, for example the connectivity of different components within the network. The global processor may be arranged to correlate the arrangement of the electrical distribution network with the signals from the plurality of local processors. This may be used to identify the location of series arcing within the electrical distribution network, as the global processor may identify the pattern in the signals indicative of series arcing within a particular component. This may be encoded in the signal output by the global processor indicating series arcing and may be useful when preventing further series arcing, e.g. by replacing worn component parts.

Furthermore, by having a knowledge of the different components in the electrical distribution network, the global processor may be able to identify different faults in the components other than series arcing, e.g. by identifying patterns in the signals received from the plurality of local processors indicative of other faults, such as a capacitor failure.

In some examples, the global processor is arranged to determine the severity of series arcing in the electrical distribution network and output a signal indicative of the severity of the series arcing, e.g. by identifying signals that have a much higher complexity when compared to other signals from the plurality of local processors. The faults may be identified faster compared to conventional devices, as no time/frequency analysis may be required by the local or global processors. Therefore, a severe series arcing fault may be identified quickly and resolved before it starts to cause any major issues to the aircraft, e.g. if severe turbulence has caused a connector to come loose.

In some examples, the system comprises a power distribution unit connected to the electrical distribution network, wherein the power distribution unit is arranged to selectively control the power supplied to the components of the electrical distribution network. The global processor may output the signal indicative of series arcing to the power distribution unit. For example, the power distribution unit may supply power to each component within the electrical distribution network. Therefore, when the global processor identifies series arcing in a given electrical component, the output signal may be fed to the power distribution unit, such that the power distribution unit may be able to reduce or remove power from the affected component (i.e. in which series arcing has been identified).

For example, the power distribution unit may remove or reduce power from the affected electrical component (when series arcing has been identified in that component) and thus prevent series arcing further degrading the component. The power distribution unit may supply power to a different electrical component, or reroute the flow of power (when series arcing has been identified in a component), in order to avoid placing too high a voltage across the electrical component in which series arcing is occurring.

In some examples, the process of removing power from a component or portion of the electrical distribution network with the power distribution unit may be fully automated by the system, e.g. using the global processor. This may allow for the pilot to concentrate on other issues within the aircraft when the fault is determined. However, in some examples, the series arcing fault is flagged to the pilot, e.g. using a flight management system, for example to give the option to the pilot on how to resolve the fault, e.g. by emergency landing of the plane, or by removing the power from the affected component and compensating other aircraft systems as a result.

The power distribution unit may be in communication with the global processor to help identify false positives of series arcing. For example, the global processor may identify series arcing in a component, but the power distribution unit may indicate that no power is actually being supplied to that component at that time, and thus this is a false positive.

In some examples, the global processor is arranged to output the signal indicating series arcing to a maintenance log. The maintenance log may be updated over the duration of the flight of the aircraft. This may be useful when series arcing faults are detected that are so severe that they need to be addressed during flight of the aircraft, however they could get worse over time and thus need to be addressed during aircraft maintenance. For example, the information in the maintenance log may include the location of the series arcing fault and the severity of the fault.

In some examples, the global processor is arranged to use a machine learning algorithm to identify a pattern in the signals received from the plurality of local processors to determine when series arcing is occurring. For example, the global processor may use supervised machine learning, e.g. the global processor may be in communication with a memory that stores information relating to patterns indicative of series arcing across different components of the electrical distribution network, such that the global processor may then identify and classify patterns indicative of series arcing.

The global processor may use unsupervised machine learning to identify patterns in the signals received from the local sensors, to group the different patterns and thus identify which patterns are associated with series arcing. This may be useful when identifying series arcing behaviours in components that are not yet severe enough to significantly increase the noise on a particular measurement, but still creates a pattern in the noise and hence complexities of the signals. This may prevent series arcing from significantly degrading a component within the electrical distribution network before the fault is identified.

In some examples, the global processor is arranged to compare the signals from the plurality of local processors to determine when series arcing is occurring, e.g. using an algorithm. For example, the algorithm may compare the complexities of the voltage, current and/or impedance measurements measured by each local sensor for each component, and compare these complexities to the complexities of the measurements taken for other nearby components. For example, the algorithm may be arranged such that if the complexities of the voltage measurements for all components within a certain region of the load of the electrical distribution network are high, but the impedances are all low, the global processor may output a signal indicative of series arcing within that region of the electrical distribution network.

In some examples, the system further comprises a memory, wherein the memory is arranged to store information relating to the normal behaviour of the electrical distribution network, wherein the global processor is arranged to compare the signals from the plurality of local processors to the normal behaviour of the electrical distribution network to determine when series arcing is occurring. For example, the normal behaviour of a series of components may be a particular degree of complexity of each of the measurements measured by the local sensors.

The global processor may be arranged to compare the complexities of the signals received from the plurality of local processors to their expected values if no series arcing were to be occurring, and raise (and, e.g., output) a signal indicative of series arcing if there is a deviation from the expected values. For example, the global processor may be arranged to raise (and, e.g., output) a signal indicative of series arcing if one or more of the signals are significantly higher or lower than their expected values (e.g. over two standard deviations away). This may be useful when only a few local sensors are monitoring the electrical distribution network, and thus it would not be suitable to try and detect a pattern in the complexities of the signals.

In some examples, the global processor is arranged to output a signal indicating that the electrical distribution system is operating normally when no series arcing is detected. For example, this may be useful to output to other safety monitoring systems on the aircraft, such as a circuit protection device, which may be useful to prevent nuisance tripping. Nuisance tripping occurs in aircrafts where circuit protection devices responsible for protection of electrical circuits from low impedance faults open circuit portions of the electrical distribution network without a fault being present. This may have a negative impact on aircraft performance, and require effort to diagnose and resolve.

Examples of the disclosure may thus allow for quick identification of false positives that cause nuisance tripping, e.g. use of a passenger mobile device during flight, and confirmation that the electrical distribution network is operating normally.

In some examples, the plurality of local processors are connected to the global processor by a data bus, e.g. a CAN (controller area network) bus, RS485, AFDX (avionics full-duplex switched ethernet), or other aircraft bus that operates at relatively low data rates. As the signals transmitted from the plurality of local processors to the global processor are indicative of the complexity of the measurement, they may not require a high speed data transfer link, because the complexity of the signals themselves are low and do not have a time domain component. Therefore, the connections between the local processors and the global processor may be simplified, compared to were each local sensor to output the measurements directly to the global processor. This may allow for a less-specialised, lower-cost data bus to be used, that does not require specialist communications cables to help to ensure noise immunity.

Thus it will be seen that, in at least some examples, the system for and method of identifying series arcing may allow for an accurate determination of series arcing within an electrical distribution network, without a high data cost. For example, the system and method may be used within a global health monitoring system of an aircraft.

It will be appreciated by the skilled person that not every component in the electrical distribution network may be active throughout flight of the aircraft. For example, some components may only have power supplied to them during take-off and/or landing of the aircraft. Therefore, in some examples, the global processor may be in communication with a flight management system of the aircraft, to determine which components are active and thus which components should be included when analysing the signals from the local processors to determine if series arcing is occurring.

## BRIEF DESCRIPTION OF THE DRAWINGS

One or more non-limiting examples will now be described, by way of example only, and with reference to the accompanying figures in which:

Figure 1 shows schematically a system for identifying series arcing in an aircraft electrical distribution network;
Figure 2 shows a flow chart of the process for identifying series arcing in an aircraft electrical distribution network; and
Figures 3a and 3b show the process performed by the local processor in Figure 1 on a current and voltage trace respectively.

## DETAILED DESCRIPTION

The examples described herein may be used for the detection of series arcing in an aircraft. Other uses, however, are also envisaged and the examples are not limited to this.

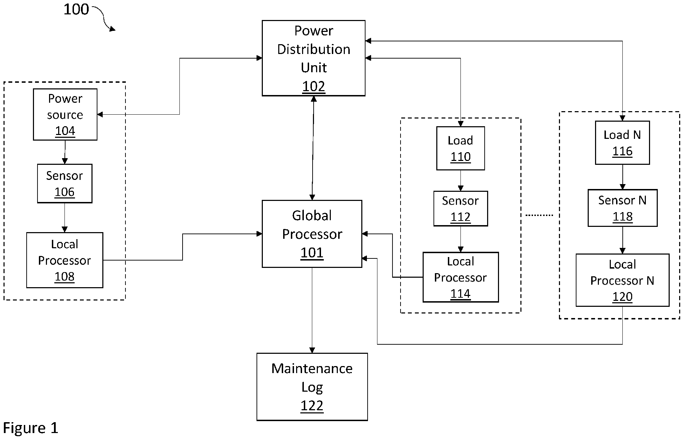

Figure 1 shows a schematic diagram of a system 100 for identifying series arcing. The electrical distribution network of the aircraft includes a power source 104, and a plurality of load components, from a first load 110 to a Nth load 116. For example, the load components may include actuators, regulators and other electrical systems within the aircraft. The skilled person will appreciate that N may depend on the size of the aircraft and the number of load components being monitored by the system 100. The plurality of load components 110, 116 and the power source 104 are connected to a power distribution unit 102, which is arranged to distribute the power from the power source 104 to the plurality of load components 110, 116.

The power source 104 and the load components 110, 116 are each monitored by a respective sensor 106, 112, 118. Each sensor 106, 112, 118 measures the voltage, current and/or impedance through the respective component and outputs this measurement to a respective local processor 108, 114, 120. For example, the sensor measurement from each sensor 106, 112, 118 may be a waveform of the voltage, current and/or impedance over a given period of time, e.g. over a period of one second. The skilled person will appreciate that the time period of measurement may be selected for each component and/or each measurement of voltage, current and/or impedance depending on the time period over which fluctuations in the waveform are expected to be seen for a given component.

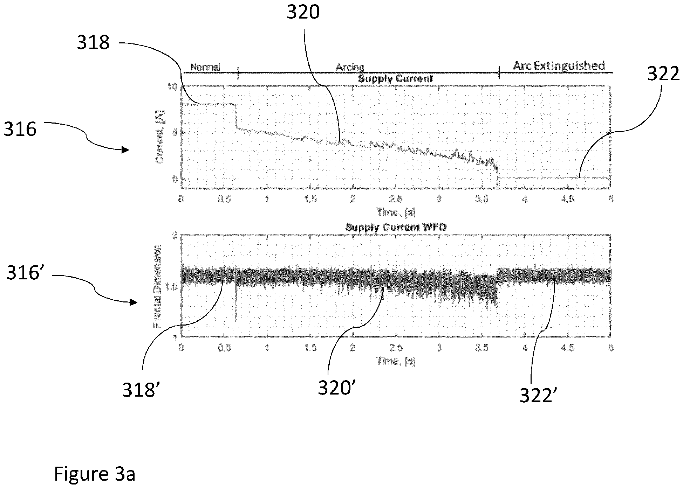

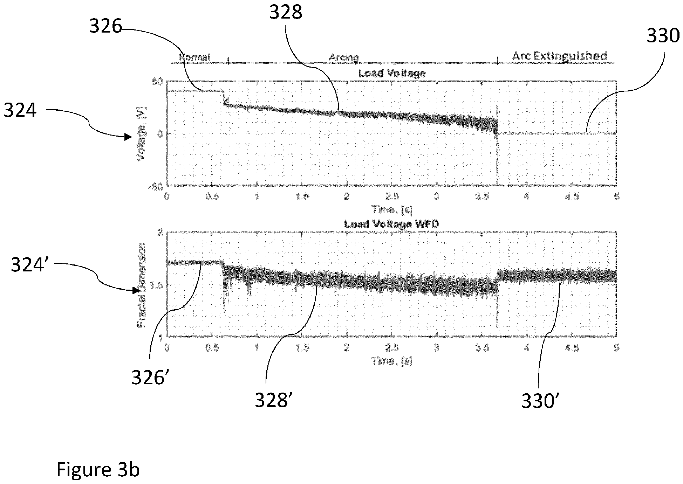

Each local processor 108, 114, 120 receives the measurement output from the respective sensor 106, 112, 118. The local processors 108, 114, 120 analyse the measurements in order to determine the complexity of each measurement, e.g. the noise on each measurement. For example, the complexity may be determined using fractal dimension analysis, as described below with reference to Figure 3. Each local processor 108, 114, 120 outputs a signal indicative of the complexity of the measurements taken by the respective local sensor to the global processor 101.

The global processor 101 receives information from all of the components 104, 110, 116 in the electrical distribution network with an associated sensor 106, 112, 118 in the form of a single number that does not have a time dependence. Each signal is a number indicative of the complexity (i.e. noise) of the voltage, current and/or impedance measurement and thus can be transmitted quickly to the global processor 101 from the local processors 108, 114, 120, without the need for a high speed data connection. This greatly simplifies the data received by the global processor 101 and reduces the data that needs to be sent over time.

The global processor 101 analyses the signals received from the plurality of local processors 108, 114, 120, in order to identify when and where series arcing is occurring. For example, the global processor 101 may use machine learning to identify patterns in the complexities of the signals received and correlate these patterns with behaviour indicative of series arcing in a given component 103, 110, 116 or portion of the electrical distribution network.

If the global processor 101 analyses the signals and determines that series arcing is occurring, the global processor 101 may flag this in a maintenance log 122 of the aircraft. This may allow for the component or connection that is causing series arcing to be replaced or adjusted during maintenance of the aircraft between flights.

The global processor may also send a signal indicative of series arcing in a particular component to the power distribution unit 102. The power distribution unit 102 may then remove or reduce the power being supplied to the component or circuit portion where series arcing is occurring. This may be useful if the series arcing is severe and thus should be addressed during the flight to avoid damage to the rest of the electrical distribution network or aircraft and/or if the circuit portion in question is not vital to the operation of the aircraft and thus can be retired until it is fixed.

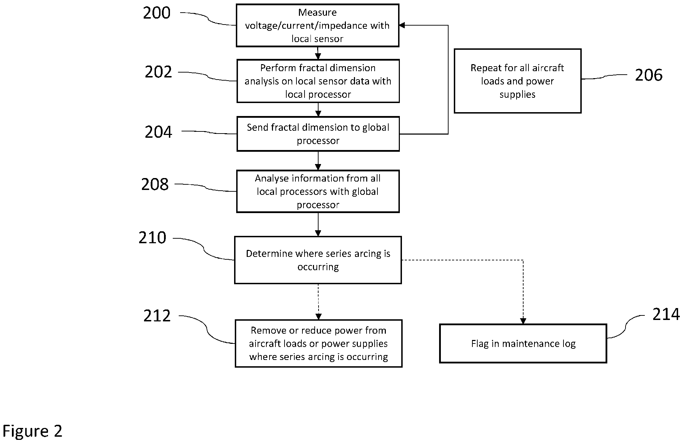

Figure 2 depicts a flow chart of the method for identifying series arcing in an electrical distribution network. This process involves a sequence of steps that takes place within a system of the aircraft, e.g. the system 100 shown in Figure 1. The system for identifying series arcing in an electrical distribution network may include, be part of, or be separate from the electrical distribution network of the aircraft and flight management system of the aircraft.

At step 200, a local sensor measures the voltage, current and/or impedance through a given component. The local sensor outputs this measurement to a local processor where, at step 202, the local processor performs fractal dimension analysis on the measurement to determine the complexity of, and therefore the noise associated with, the measurement measured by the local sensor. The local sensor outputs this signal indicative of the complexity of the measurement to the global processor at step 204.

At step 206, the steps 200-204 are repeated for the local sensors associated with each component. It will be appreciated by the skilled person that each local processor may be independent, and therefore the measurements and analysis by the local sensors and processors may occur in parallel, e.g. the global processor may receive the signals from all local processors at step 204 at substantially the same time.

At step 208, the global processor has received the signals from the local processors regarding the complexity of the measurements from each local sensor and can thus analyse these signals. The global processor may compare the signals in order to identify any patterns in the signals, to determine where and when series arcing is occurring at step 210.

When the global processor has determined where and when series arcing is occurring, the global processor will output a signal indicative of the series arcing. This signal may be sent to a maintenance log at step 214 and/or be sent to the power distribution unit of the aircraft at step 212.

For example, if the series arcing is determined by the global processor to be severe enough that it needs to be addressed immediately, the signal may be sent to the power distribution unit at step 212. At step 212, the power is removed from the loads in the electrical distribution network where series arcing is occurring. For example, the power distribution unit may re-route the power to a different component unaffected by series arcing, e.g. a previously redundant component. For components that cannot have the power supply removed, the power supply may be reduced. For power supplies affected by series arcing, the load demand may be reduced or removed by the power distribution unit.

In addition to sending the signal to the power distribution unit at step 212, or if the series arcing is determined by the global processor to not be severe, a signal may be sent to the maintenance log at step 214. This may allow for the component or connection that is causing series arcing to be replaced or adjusted during maintenance of the aircraft between flights.

Figure 3a shows the process performed by the local processor shown in Figure 1 to determine the complexity of the current measurement measured by the local sensor.

The current graph 316 shows a current trace before series arcing 318, during series arcing 320, and after series arcing 322. The current trace before series arcing 318 is high, with no noise on the signal, i.e. a low complexity. The current trace during series arcing then rapidly drops, with a large amount of noise on signal, i.e. a high complexity. The current trace after series arcing, i.e. when the arc has been extinguished, is low, with no noise on the signal, i.e. a low complexity. The local processor receives the first current trace 316 from the local sensor, and converts it into a fractal dimension trace 316'.

The fractal dimension current graph 316' shows the fractal dimension of the current graph before series arcing 318', during series arcing 320', and after series arcing 322', as processed by the local processor. The fractal dimension of the current before and after series arcing 318' and 322' is the same, as the complexities of these signals is the same, such that the number fed to the global processor in both of these states is above 1.5. However, the fractal dimension during series arcing drops towards 1, as the complexity of this current trace is much higher. Therefore, the global processor may detect a change in the fractal dimension of the current trace, and thus output a signal indicative of series arcing in a component.

Detecting series arcing using the fractal dimension trace 316' is simpler than using the current trace 316, as the fractal dimension trace 316' only changes significantly in magnitude during series arcing, e.g. when noise on the signal increases, whereas the current trace 316 varies in magnitude before and after series arcing. Therefore, far fewer numbers need to be fed to the global processor to detect series arcing using the fractal dimension trace 316'.

Figure 3b shows the process performed by the local processor shown in Figure 1 to determine the complexity of the voltage measurement measured by the local sensor.

The voltage graph 324 shows a voltage trace before series arcing 326, during series arcing 328, and after series arcing 330. The voltage trace before series arcing 318 is high, with no noise on the signal, i.e. a low complexity. The voltage trace during series arcing then rapidly drops, with a large amount of noise on signal, i.e. a high complexity. The voltage trace after series arcing, i.e. when the arc has been extinguished, is low, with no noise on the signal, i.e. a low complexity. The local processor receives the first voltage trace 316 from the local sensor, and converts it into a fractal dimension trace 316'.

The fractal dimension voltage graph 324' shows the fractal dimension of the voltage graph before series arcing 326', during series arcing 328', and after series arcing 330', as processed by the local processor. The fractal dimension of the voltage before and after series arcing 324' and 330' above 1.5, as the complexities of both of these signals is low. However, the fractal dimension during series arcing drops towards 1, as the complexity of this voltage trace is much higher. Therefore, the global processor may detect a change in the fractal dimension of the voltage trace, and thus output a signal indicative of series arcing in a component.

Detecting series arcing using the fractal dimension trace 324' is simpler than using the voltage trace 324, as the fractal dimension trace 324' only changes significantly in magnitude during series arcing, e.g. when noise on the signal increases, whereas the voltage trace 324 varies in magnitude before and after series arcing. Therefore, far fewer numbers need to be fed to the global processor to detect series arcing using the fractal dimension trace 324'.

The fractal dimensions of the current and voltage traces 316', 324' may be compared by the global processor, in order to determine if series arcing is occurring. For example, the global processor may only flag series arcing if both the current and voltage traces 316', 324' drop below a fractal dimension of 1.5 at the same time.

## Claims

1. A system for identifying series arcing in an electrical distribution network of an aircraft, comprising:

a plurality of local sensors;
wherein each local sensor is arranged to measure a measurement representative of the voltage, current and/or impedance in a component of the electrical distribution network;
a plurality of local processors;
wherein each local processor is arranged to analyse the measurement measured by the respective local sensor and output a signal representative of the complexity of the measurement;
a global processor arranged to receive the signals from the plurality of local processors;

wherein the global processor is arranged to analyse the signals and determine when series arcing is occurring in the electrical distribution network; and

wherein the global processor is arranged to output a signal indicative of the series arcing in the electrical distribution network, when it has been determined that series arcing is occurring.

2. The system as claimed in claim 1, wherein each local processor is arranged to perform fractal dimension analysis on the measurement measured by the respective local sensor to determine the complexity of the measurement.

3. The system as claimed claim 1 or 2, wherein the global processor is arranged to output a signal indicative of the location of series arcing in the electrical distribution network.

4. The system as claimed claim 1, 2 or 3, wherein the global processor is arranged to receive information regarding the arrangement of the electrical distribution network and correlate the arrangement of the electrical distribution network with the signals from the plurality of local processors to determine the location of the series arcing.

5. The system as claimed in any preceding claim, wherein the global processor is arranged to determine the severity of the series arcing in the electrical distribution network and output a signal indicative of the severity of the series arcing.

6. The system as claimed in any preceding claim, wherein the system comprises a power distribution unit connected to the electrical distribution network;

wherein the power distribution unit is arranged to selectively control the power supplied to the components of the electrical distribution network; and
wherein the global processor is arranged to output the signal indicative of series arcing to the power distribution unit.

7. The system as claimed in claim 6, wherein the power distribution unit is arranged to reduce or remove the power supply to the component in which series arcing has been identified.

8. The system as claimed in any preceding claim, wherein the global processor is arranged to output the signal indicating series arcing to a maintenance log.

9. The system as claimed in any preceding claim, wherein the global processor is arranged to use a machine learning algorithm to identify a pattern in the signals received from the plurality of local processors to determine when series arcing is occurring.

**10.** The system as claimed in any preceding claim, wherein the global processor is arranged to compare the signals from the plurality of local processors to determine when series arcing is occurring.

**11.** The system as claimed in any preceding claim, wherein the system comprises a memory;

wherein the memory is arranged to store information relating to the normal behaviour of the electrical distribution network; wherein the global processor is arranged to compare the signals from the plurality of local processors to the normal behaviour of the electrical distribution network to determine when series arcing is occurring.

**12.** The system as claimed in any preceding claim, wherein each signal from the plurality of local processors is only a single number.

**13.** The system as claimed in any preceding claim, wherein the global processor is arranged to output a signal indicating that the electrical distribution system is operating normally when no series arcing is detected.

**14.** The system as claimed in any preceding claim, wherein the plurality of local processors are connected to the global processor via a standard communications bus.

**15.** A method for identifying series arcing in an electrical distribution network of an aircraft, comprising:

each local sensor of a plurality of local sensors measuring a measurement representative of the voltage, current and/or impedance in a component of the electrical distribution network; each local processor of a plurality of local processors analysing the measurement measured by the respective local sensor and outputting a signal representative of the complexity of the measurement; a global processor receiving the signals from the plurality of local processors; the global processor analysing the signals and determining when series arcing is occurring in the electrical distribution network; the global processor outputting a signal indicative of the series arcing in the electrical distribution network, when it has been determined that series arcing is occurring.

100

Power
Distribution
Unit
102

Power
source
104

Sensor
106

Local
Processor
108

Global
Processor
101

Load
110

Sensor
112

Local
Processor
114

Load N
116

Sensor N
118

Local
Processor N
120

Maintenance
Log
122

Figure 1

200 — Measure voltage/current/impedance with local sensor

202 — Perform fractal dimension analysis on local sensor data with local processor

204 — Send fractal dimension to global processor

206 — Repeat for all aircraft loads and power supplies

208 — Analyse information from all local processors with global processor

210 — Determine where series arcing is occurring

212 — Remove or reduce power from aircraft loads or power supplies where series arcing is occurring

214 — Flag in maintenance log

Figure 2

EP 4 621 419 A1

Figure 3a

12

Figure 3b

# EP 4 621 419 A1

**EUROPEAN SEARCH REPORT**

Application Number

EP 24 16 4652

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LE VU ET AL: "Series Arc Fault Detection and Localization in DC Distribution Based on Master Controller", 2020 IEEE ENERGY CONVERSION CONGRESS AND EXPOSITION (ECCE), IEEE, 11 October 2020 (2020-10-11), pages 2499-2504, XP033850662, DOI: 10.1109/ECCE44975.2020.9235651 [retrieved on 2020-10-21] | 1,3,4, 10,12-15 | INV. G01R19/00 G01R31/12 G01R31/58 H02H1/00 H02H3/44 |
| Y | * page 2499 - page 2502 * | 2,5-8,11 | |
| X | YAO XIU ET AL: "DC Arc detection and protection in DC based electrical systems", 2017 IEEE ENERGY CONVERSION CONGRESS AND EXPOSITION (ECCE), IEEE, 1 October 2017 (2017-10-01), pages 1-102, XP033247616, DOI: 10.1109/ECCE.2017.8096980 [retrieved on 2017-11-03] | 1,13-15 | |
| Y | * pages 1,5,58 * | 2,5-8,11 | **TECHNICAL FIELDS SEARCHED (IPC)** |
| X | LE VU ET AL: "Series Arc Fault Identification in DC Distribution Based on Random Forest Predicted Probability", IEEE JOURNAL OF EMERGING AND SELECTED TOPICS IN POWER ELECTRONICS, IEEE, PISCATAWAY, NJ, USA, vol. 11, no. 6, 9 December 2022 (2022-12-09), pages 5636-5648, XP011954830, ISSN: 2168-6777, DOI: 10.1109/JESTPE.2022.3228421 [retrieved on 2022-12-12] | 1,3,9, 12-15 | G01R H02H |
| Y | * page 5636 - page 5640 * * figure 1 * | 2,5-8,11 | |

-/--

The present search report has been drawn up for all claims

| Place of search | Date of completion of the search | Examiner |
|---|---|---|
| The Hague | 28 August 2024 | Breccia, Luca |

page 1 of 2

Europäisches
Patentamt

European
Patent Office

Office européen
des brevets

# EUROPEAN SEARCH REPORT

**Application Number**

EP 24 16 4652

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | SEELEY DANNY ET AL: "DC Series Arc Fault Detection Using Fractal Theory", 2023 IEEE INTERNATIONAL CONFERENCE ON ELECTRICAL SYSTEMS FOR AIRCRAFT, RAILWAY, SHIP PROPULSION AND ROAD VEHICLES & INTERNATIONAL TRANSPORTATION ELECTRIFICATION CONFERENCE (ESARS-ITEC), IEEE, 29 March 2023 (2023-03-29), pages 1-6, XP034341004, DOI: 10.1109/ESARS-ITEC57127.2023.10114909 [retrieved on 2023-05-11] * page 2, column 1, line 10 - line 13 * | 2 | |
| Y | CN 114 019 252 A (STATE GRID JIANGSU ELECTRIC POWER CO RES INST ET AL.) 8 February 2022 (2022-02-08) * figure 1 * | 5 | |
| Y | WO 99/26328 A1 (SQUARE D CO [US]) 27 May 1999 (1999-05-27) * page 10, line 11 - page 11, line 8 * | 6,7 | TECHNICAL FIELDS SEARCHED (IPC) |
| Y | KR 101 692 283 B1 (SMART POWER SUPPLY CO LTD [KR]) 17 January 2017 (2017-01-17) * paragraph [0027] * | 8 | |
| Y | KR 2020 0049919 A (KRRI [KR]) 11 May 2020 (2020-05-11) * paragraph [0017] * | 11 | |

The present search report has been drawn up for all claims

| Place of search | Date of completion of the search | Examiner |
|---|---|---|
| The Hague | 28 August 2024 | Breccia, Luca |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 4652

This annex lists the patent family members relating to the patent documents cited in  the above-mentioned European search report.
The members are as contained in the European Patent Office EDP file on
The European Patent Office is in no way liable for these particulars which are merely given for the purpose of information.

28-08-2024

| Patent document cited in search report | | Publication date | Patent family member(s) | | Publication date |
|---|---|---|---|---|---|
| CN 114019252 | A | 08-02-2022 | NONE | | |
| WO 9926328 | A1 | 27-05-1999 | AU | 1459399 A | 07-06-1999 |
| | | | CA | 2310619 A1 | 27-05-1999 |
| | | | EP | 1034591 A1 | 13-09-2000 |
| | | | MY | 116301 A | 31-12-2003 |
| | | | WO | 9926328 A1 | 27-05-1999 |
| KR 101692283 | B1 | 17-01-2017 | NONE | | |
| KR 20200049919 | A | 11-05-2020 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20220099724 A1